# EUROPEAN PATENT APPLICATION

(11) **EP 4 787 261 A1**
(43) Date of publication of application: **05.08.2026**
(21) Application number: 26154460.5
(22) Date of filing: 27.01.2026
(51) Int. Cl.: G06Q 10/087, G06Q 10/20, H05K 5/02

(54) **MANAGEMENT SYSTEM, FIELD DEVICE, MANAGEMENT APPARATUS, AND MANAGEMENT METHOD**

(30) Priority: 31.01.2025 JP 2025014518
(71) Applicant: Yokogawa Electric Corporation, Musashino-shi, Tokyo 180-8750 (JP)
(72) Inventor: KAJIMOTO, Kazunori, Musashino-shi, Tokyo 180-8750 (JP)
(74) Representative: Winter, Brandl - Partnerschaft mbB

(57) **Abstract**

In a management system (1), a first nameplate with writing of which content is not updated and a second nameplate that is replaceable, that is with writing of which content is updatable, and that is in a pair with the first nameplate are fixed to a housing of a pressure transmitter (10) and a management apparatus (20) manages a history of updating the content of writing on the second nameplate. For example, serial numbers that are identical are written on the first nameplate and the second nameplate. For example, information on the pressure transmitter (10) that is the latest and that is changeable is written on the second nameplate. For example, the management apparatus (20) adds a photograph of the first nameplate and the second nameplate that are subjects to the history of the updating. For example, the history of the updating is updated by a mobile terminal device (30) that is able to communicate with the management apparatus (20).

## Description

### FIELD

The present disclosure relates to a management system, a filed device, a management apparatus, and a management method.

### BACKGROUND

A nameplate with information on each field device, such as a pressure transmitter, a temperature transmitter or a flow transmitter, (sometimes referred to as "device information" below) is fixed to a housing of each field device.

An example of related-art is described in Japanese Laid-open Patent Publication No. 2009-272164.

When a functional enhancement, a functional change, a setting change, or the like, on a field device is made, a change is caused in the device information and accordingly the content of writing on the nameplate is updated. When the nameplate is detached from the field device to update the content of writing on the nameplate, association between the field device and the nameplate is not clear and thus it is sometimes difficult to determine to which field device the nameplate with writing of which content is updated (sometimes referred to as "updated nameplate" below) should be fixed. For this reason, there is a risk that the updated nameplate will be fixed to a field device other than the updated field device to which the nameplate should be fixed. When the updated nameplate is fixed incorrectly to a field device other than the field device to which the nameplate should be fixed, because discrepancy occurs between the content of writing on the nameplate and the actual device information, it is difficult to manage the field device.

### SUMMARY

According to an aspect of an embodiment, a management system includes a field device and a management apparatus. The field device has a housing to which a first nameplate with writing of which content is not updated and a second nameplate that is replaceable, that is with writing of which content is updatable, and that is in a pair with the first nameplate are fixed. The management apparatus manages a history of updating the content of writing on the second nameplate.

### BRIEF DESCRIPTION OF THE DRAWINGS

FIG. 1 is a diagram illustrating an example of a configuration of a management system of a first embodiment of the present disclosure;
FIG. 2 is a diagram illustrating an example of fixation of a nameplate to a pressure transmitter of the first embodiment of the disclosure;
FIG. 3 is a diagram illustrating an example of a configuration of a management apparatus of the first embodiment of the disclosure;
FIG. 4 is a diagram illustrating an example of a process procedure taken by the management system of the first embodiment of the disclosure;
FIG. 5 is a diagram illustrating an example of writing on a first nameplate and a second nameplate of the first embodiment of the disclosure;
FIG. 6 is a diagram illustrating an example of management information of the first embodiment of the disclosure;
FIG. 7 is a diagram illustrating an example of an operation of the management system of the first embodiment of the disclosure;
FIG. 8 is a diagram illustrating an example of an operation of the management system of the first embodiment of the disclosure;
FIG. 9 is a diagram illustrating an example of an operation of the management system of the first embodiment of the disclosure;
FIG. 10 is a diagram illustrating an example of an operation of the first embodiment of the disclosure;
FIG. 11 is a diagram illustrating an example of an operation of the first embodiment of the disclosure;
FIG. 12 is a diagram illustrating an example of an operation of the first embodiment of the disclosure;
FIG. 13 is a diagram illustrating an example of an operation of the first embodiment of the disclosure;
FIG. 14 is a diagram illustrating an example of an operation of the first embodiment of the disclosure;
FIG. 15 is a diagram illustrating an example of an operation of the first embodiment of the disclosure;
FIG. 16 is a diagram illustrating an example of an operation of the first embodiment of the disclosure;
FIG. 17 is a diagram illustrating an example of an operation of the first embodiment of the disclosure;
FIG. 18 is a diagram illustrating an example of an operation of the first embodiment of the disclosure;
FIG. 19 is a diagram illustrating an example of an operation of the first embodiment of the disclosure;
FIG. 20 is a diagram illustrating an example of an operation of the first embodiment of the disclosure;
FIG. 21 is a diagram illustrating an example of an operation of the first embodiment of the disclosure;
FIG. 22 is a cross-sectional view of a pressure transmitter of a second embodiment of the disclosure; and
FIG. 23 is a cross-sectional view of the pressure transmitter of a second embodiment of the disclosure.

### DESCRIPTION OF EMBODIMENTS

Embodiments of the present disclosure will be described below according to the accompanying drawings.

Note that, in the following embodiments, the same parts or the same processes are denoted with the same reference numerals and thereby redundant description thereof are sometimes omitted.

A pressure transmitter is taken as an example of a field device and is described below.

Note that the technique of the disclosure is also applicable to field devices other than pressure transmitters (for example, temperature transmitters, flow transmitters, electromagnetic flowmeters, vortex flowmeters, and Coriolis mass flowmeters).

### First Embodiment

### Configuration of Management System

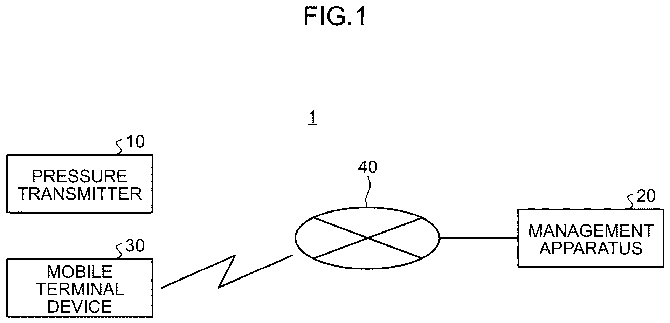

FIG. 1 is a diagram illustrating an example of a configuration of a management system of a first embodiment of the present disclosure. The management system 1 in FIG. 1 includes a pressure transmitter 10, a management apparatus 20, and a mobile terminal device 30. The management apparatus 20 and the mobile terminal device 30 are connected via a network 40. Note that, a terminal device, such as a personal computer, is usable instead of the mobile terminal device 30.

The management apparatus 20 is used by a manufacturer of the pressure transmitter 10 (sometimes referred to as a "device manufacturer" below). The mobile terminal device 30 is used by a user of the pressure transmitter 10 (sometimes referred to as a "device user" below). A computer, such as a server, is taken as an example of the management apparatus 20. A smart device, such as a tablet terminal device, is taken as an example of the mobile terminal device 30.

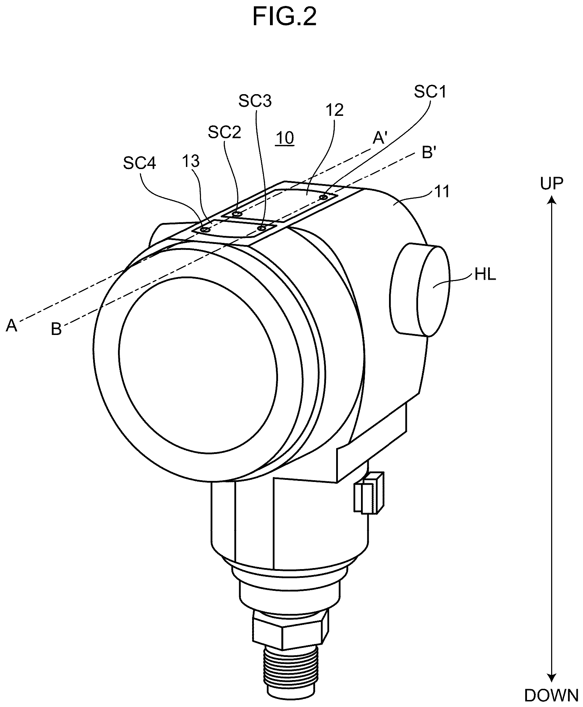

FIG. 2 is a diagram illustrating an example of fixation of a nameplate to the pressure transmitter of the first embodiment of the disclosure. Two nameplates that are a first nameplate 12 and a second nameplate 13 are fixed to a housing 11 of the pressure transmitter 10. For example, the first nameplate 12 and the second nameplate 13 are fixed to a flat top surface of the housing 11 vertically. The first nameplate 12 is fixed to the housing 11 by screwing using a first screw SC1 and a second screw SC2 and the second nameplate 13 is fixed to the housing 11 by screwing using a third screw SC3 and a fourth screw SC4.

Device information on the pressure transmitter 10 is written on the first nameplate 12 and the second nameplate 13. The first nameplate 12 is a nameplate with writing of which content is not updated. On the other hand, the second nameplate 13 is a nameplate that is replaceable and that is with writing of which content is changeable. Note that the first nameplate 12 is replaceable as required, for example, in the case where the print fades.

### Configuration of Management Apparatus

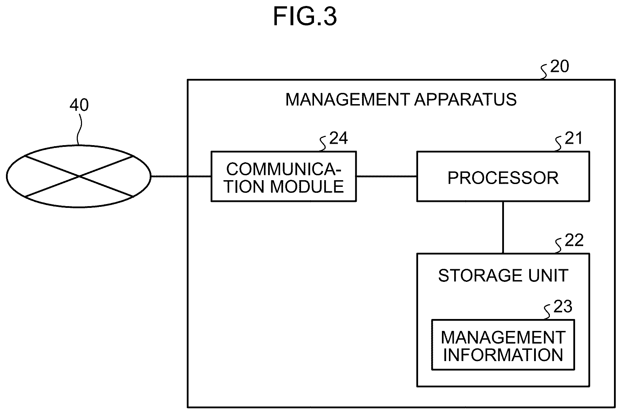

FIG. 3 is a diagram illustrating an example of a configuration of the management apparatus of the first embodiment of the disclosure. The management apparatus 20 in FIG. 3 includes a processor 21, a storage unit 22, and a communication module 24. The communication module 24 is connected to the network 40 and, using the communication module 24, the processor 21 is able to communicate with the mobile terminal device 30 via the network 40. A central processing unit (CPU) and a digital signal processor (DSP) are taken as an example of the processor 21. A storage and a memory are taken as an example of the storage unit 22.

The storage unit 22 stores management information 23 that is information by which a history of updating the second nameplate 13 is managed.

### Process Procedure taken by Management System

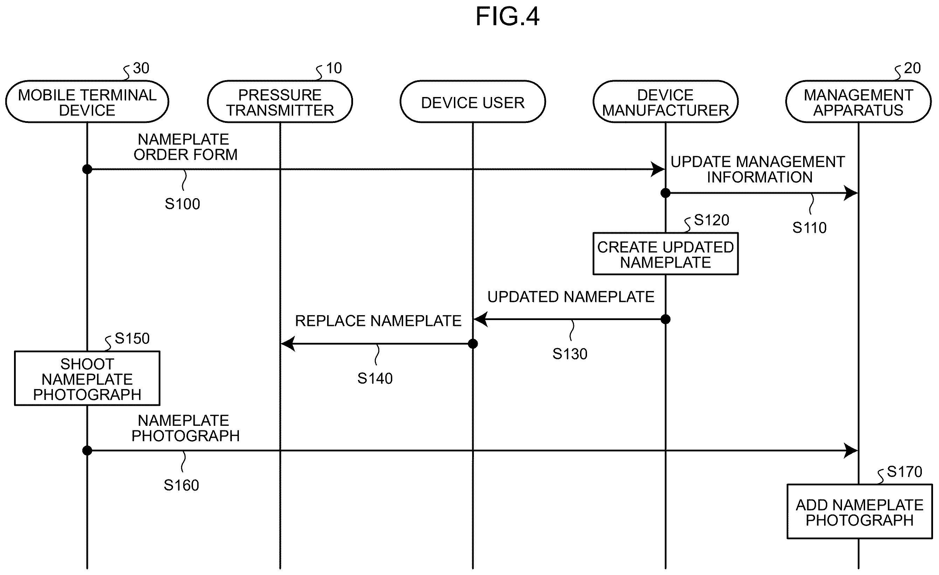

FIG. 4 is a diagram illustrating an example of a process procedure taken by the management system of the first embodiment of the disclosure.

At step S100 in FIG. 4, the device user sends an order form for the second nameplate 13 (sometimes referred to as a "nameplate order form") to the device manufacturer. For example, using the mobile terminal device 30, the device user accesses a website provided by the device manufacturer where an order form format is open and enters the content of an order for the second nameplate 13 in the order form format, thereby sending the nameplate order form to the device manufacturer. The nameplate order form created using the order form format that is open on the website is received by the processor 21 using the communication module 24 via the network 40.

Subsequently, at step S110, the device manufacturer having received the nameplate order form updates the management information 23 according to the content of the order in the nameplate order form. For example, in the case where the nameplate order form is received by the processor 21 at step S100, the processor 21 updates the management information 23 according to the content of the order in the nameplate order form.

At step S120, the device manufacturer having received the nameplate order form creates an updated nameplate based on the content of the order in the nameplate order form.

Subsequently, at step S130, the device manufacturer sends the updated nameplate that is created at step S120 to the device user.

Subsequently, at step S140, the device user having received the updated nameplate replaces the second nameplate 13 that is already fixed to the pressure transmitter 10 (sometimes referred to as an "existing nameplate" below) with the updated nameplate. Accordingly, the updated nameplate serves as a new existing nameplate.

Subsequently, at step S150, using a camera installed in the mobile terminal device 30, the device user shoots a photograph of subjects that are the first nameplate 12 and the second nameplate 13 after replacement with the updated nameplate (sometimes referred to as a "nameplate photograph" below).

Subsequently, at step S160, using the mobile terminal device 30, the device user sends the nameplate photograph to the management apparatus 20. The nameplate photograph is received by the processor 21 using the communication module 24 via the network 40.

Subsequently, at step S170, the processor 21 having received the nameplate photograph adds the management information to the nameplate photograph.

### Example of Writing on First Nameplate and Second Nameplate

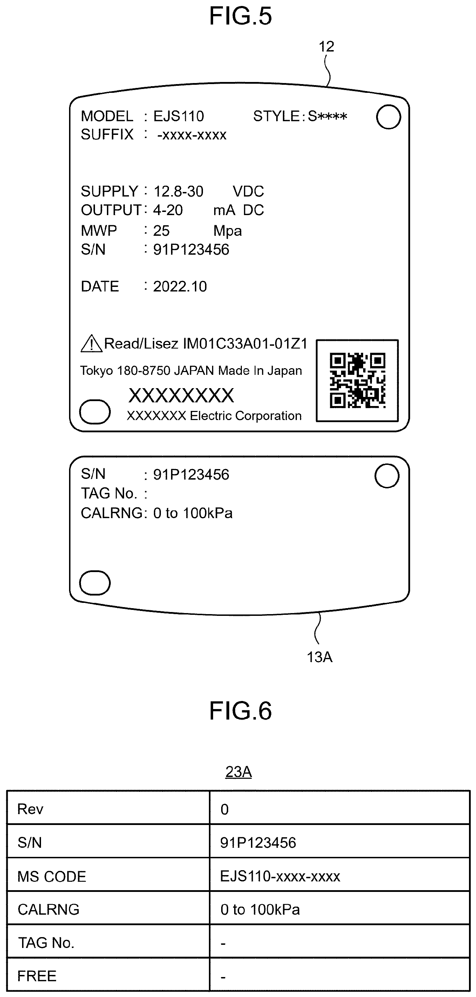

FIG. 5 is a diagram illustrating an example of writing on the first nameplate and the second nameplate of the first embodiment of the disclosure. FIG. 5 illustrates the first nameplate 12 and a second nameplate 13A that are the two nameplates fixed to the pressure transmitter 10 at the shipment of the pressure transmitter 10 from the device manufacturer.

As illustrated in FIG. 5, for example, there are "MODEL", "STYLE", "SUFFIX", "SUPPLY", "OUTPUT", "MWP", "S/N" and "DATE" as items of writing on the first nameplate 12 and the content of writing on the first nameplate is not updated. "MODEL" represents a model name of the pressure transmitter 10. "STYLE" represents an internal specification of the pressure transmitter 10. There are the pressure transmitters 10 that have the identical model name but have different internal specifications. "SUFFIX" represents a specification code at the shipment of the pressure transmitter 10. "SUPPLY" represents a power supply voltage value of the pressure transmitter 10. "OUTPUT" represents an output current value of the pressure transmitter 10. "MWP" represents a maximum operating pressure value of the pressure transmitter 10. "S/N" represents a serial number of the pressure transmitter 10 and the serial number makes it possible to uniquely specify the individual pressure transmitter 10. "DATE" represents a manufacture year and month of the pressure transmitter 10.

As illustrated in FIG. 5, for example, there are "S/N", "TAG No." and "CALRNG" as items of writing on the second nameplate 13A and, while "S/N" is an item that cannot be updated, "TAG No." and "CALRNG" are items that can be updated. The serial number identical with "91P123456" that is the serial number written in "S/N" on the first nameplate 12 that is in a pair with the second nameplate 13A is written in "S/N" on the second nameplate 13A. "TAG No." represents a designation of the pressure transmitter 10 that the device user is able to determine freely. "CALRNG" represents a calibration range of the pressure transmitter 10.

### Management Information

FIG. 6 is a diagram illustrating an example of management information of the first embodiment of the disclosure. FIG. 6 illustrates management information 23A that is the management information 23 corresponding to the first nameplate 12 and the second nameplate 13A that are illustrated in FIG. 5 (that is, the management information 23 at the shipment of the pressure transmitter 10). There are, for example, "Rev", "S/N", "MS CODE", "CALRNG", "TAG No." and "FREE" as items of the management information 23A. "Rev" represents the number of times the second nameplate 13 that is fixed to the pressure transmitter 10 whose "S/N" is "91P123456" is updated. "S/N" represents a serial number of the pressure transmitter 10. "MS CODE" represents a combination of the model name and the current specification code of the pressure transmitter (MODEL+current SUFFIX) and blank "MS CODE" represents that, for example, INDICATOR is not fixed to the pressure transmitter 10. "CALRNG" represents a calibration range of the pressure transmitter 10. "TAG No." represents a designation of the pressure transmitter 10 that the device user is able to determine freely. "FREE" is an optional comment space.

### Operations of Management System

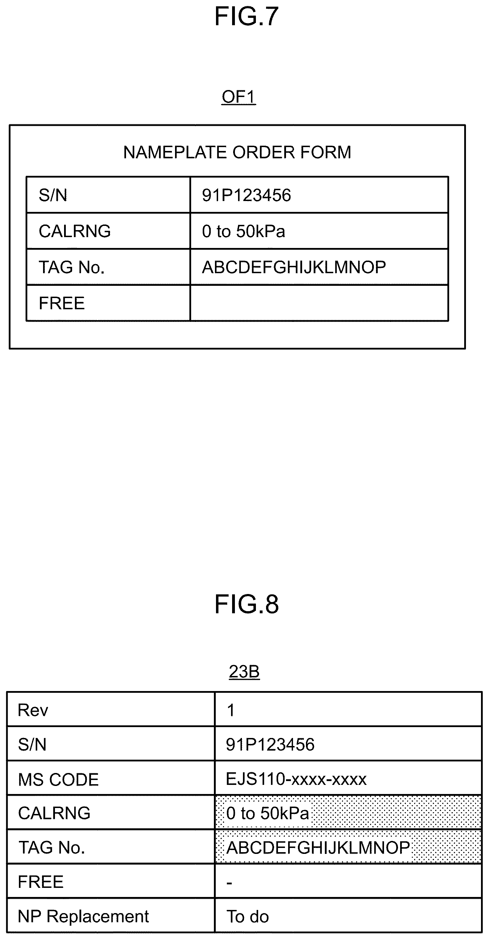

FIGS. 7 to 21 are diagrams illustrating examples of operations of the management system of the first embodiment of the disclosure.

After the pressure transmitter 10 is set, the device user who has determined to use the pressure transmitter 10 wants to change "CALRNG" from an initial value of "0 to 100 kPa" to "0 to 50 kPa" and set "ABCDEFGHIJKLMNOP" for "TAG No.", the device user creates a nameplate order form OF1 illustrated in FIG. 7 using the mobile terminal device 30 and sends the created nameplate order form OF1 to the device manufacturer (step S100). In this case, in the nameplate order form OF1, while "91P123456" is entered in "S/N", "0 to 50 kPa" is entered in "CALRNG" and "ABCDEFGHIJKLMNOP" is entered in "TAG No.", "FREE" space is blank. Thus, as for the pressure transmitter 10 whose "S/N" is "91P123456", changing the calibration range to "0 to 50 kPa" ad setting "ABCDEFGHIJKLMNOP" for "TAG No." are ordered from the device user to the device manufacturer.

In the device manufacturer having received the nameplate order form OF1, the processor 21 of the management apparatus 20 updates the management information 23 according to the nameplate order form OF1 (step S110). Based on the nameplate order form OF1, the processor 21 newly creates management information 23B illustrated in FIG. 8, thereby updating the management information 23.

When the management information 23A illustrated in FIG. 6 and the management information 23B illustrated in FIG. 8 are compared, they have the identical "S/N" that is "91P123456", they have the identical "MS code" that is "EJS110-xxxx-xxxx", and they have the same "FREE" that is blank. On the other hand, "Rev" is updated from "0" to "1", "CALRNG" is updated from "0 to 100 kPa" to "0 to 50 kPa", and "TAG No." is updated from blank to "ABCDEFGHIJKLMNOP". "NP Replacement" that is an item that is not present in the management information 23A is added to the management information 23B. When the management information 23B is created, "To do" is set for "NP Replacement". "To do" in "NP Replacement" is created by the device manufacturer according to the nameplate order form and indicates the state where replacement of the existing nameplate with the updated nameplate that is created by the device manufacturer according to the nameplate order form and that is sent from the device manufacturer to the device user has not completed.

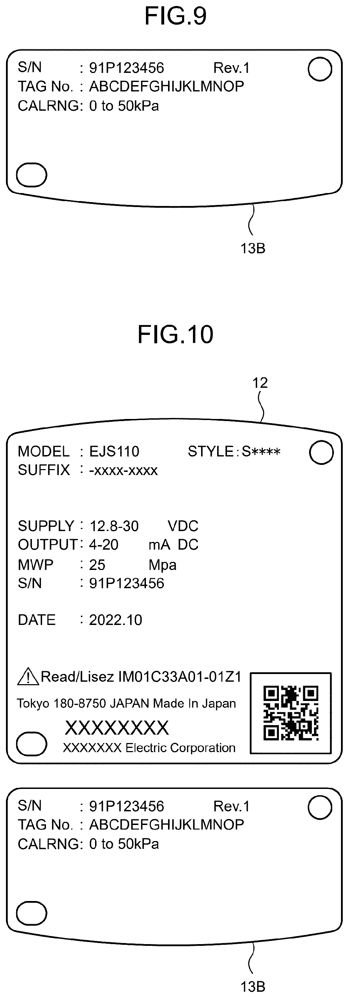

Based on the nameplate order form OF1, the device manufacturer having received the nameplate order form OF1 creates an updated nameplate 13B (FIG. 9) that is new and that is the second nameplate 13 (step S120). When the second nameplate 13A illustrated in FIG. 5 and the updated nameplate 13B illustrated in FIG. 9 are compared, while they have the identical "S/N" that is "91P123456", "TAG No." is updated from blank to "ABCDEFGHIJKLMNOP" and "CALRNG" is updated from "0 to 100 kPa" to "0 to 50 kPa". On the updated nameplate 13B, "Rev.1" indicating that the number of times the second nameplate 13 is updated is once is written. The device manufacturer sends the created updated nameplate 13B to the device user (step S130).

As illustrated in FIG. 10, with the first nameplate 12 being left in the first nameplate 12 and the second nameplate 13A (FIG. 5) that are fixed to the pressure transmitter 10, the device user having received the updated nameplate 13B replaces only the second nameplate 13 that is the second nameplate 13A (FIG. 5) with the updated nameplate 13B (FIG. 9) (step S140).

After replacement of the second nameplate 13, using the camera that is installed in the mobile terminal device 30, the device user shoots a nameplate photograph P1 of the first nameplate 12 and the updated nameplate 13B (FIG. 10) that are subjects and that are fixed to the pressure transmitter 10 (step S150).

Subsequently, using the mobile terminal device 30, the device user sends the nameplate photograph P1 to the management apparatus 20 (step S160).

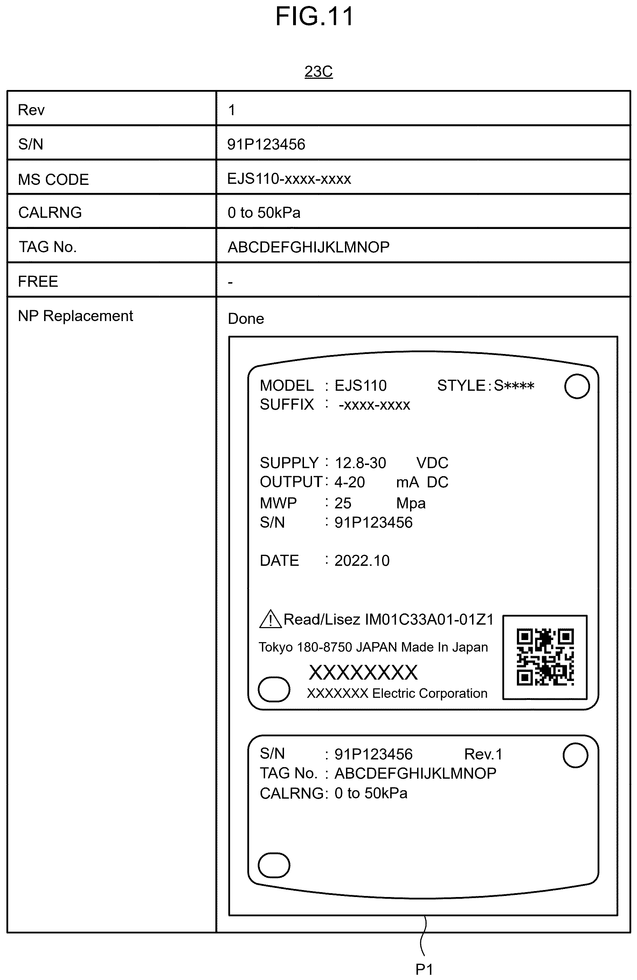

Subsequently, the processor 21 of the management apparatus 20 having received the nameplate photograph P1 adds the nameplate photograph P1 to the "NP Replacement" space in the management information 23B (FIG. 8) and updates "NP Replacement" from "To do" to "Done", thereby updating the management information 23B (FIG. 8) to management information 23C (FIG. 11) (step S170). "Done" in "NP Replacement" indicates the state where replacement of the existing nameplate with the updated nameplate that is created by the device manufacturer according to the nameplate order form and that is sent from the device manufacturer to the user has completed. In other words, addition of the nameplate photograph P1 to the "NP Replacement" space indicates that replacement of the second nameplate 13A with the updated nameplate 13B has completed.

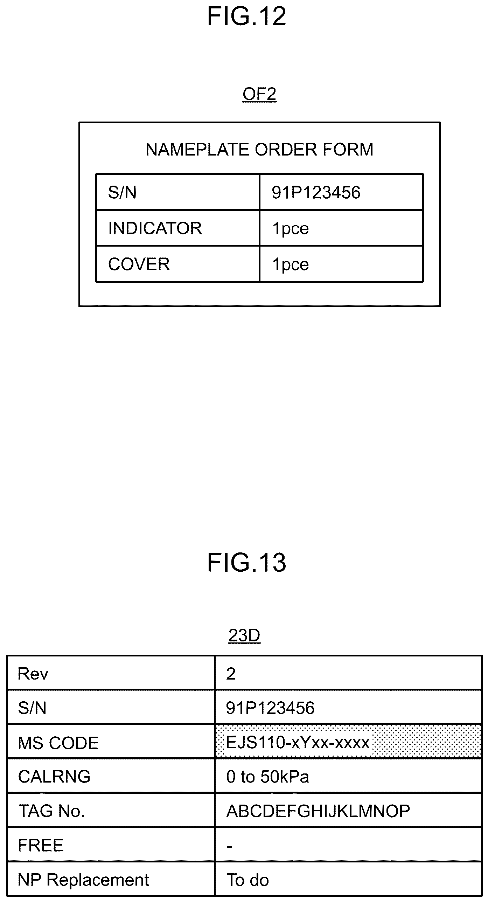

In the case where the device user wants to fix INDICATOR to the pressure transmitter 10 with the first nameplate 12 and the updated nameplate 13B being fixed to the pressure transmitter 10 as illustrated in FIG. 10, the device user creates a nameplate order form OF2 illustrated in FIG. 12 using the mobile terminal device 30 and sends the created nameplate order form OF2 to the device manufacturer (step S100). In this case, in the nameplate order form OF2, "91P123456" is entered in "S/N", "1pce" is entered in "INDICATOR", and "1pce" is entered in "COVER". Thus, as for the pressure transmitter 10 whose "S/N" is "91P123456", newly fixing INDICATOR with COVER is ordered from the device user to the device manufacturer.

In the device manufacturer having received the nameplate order form OF2, the processor 21 of the management apparatus 20 updates the management information 23 according to the nameplate order form OF2 (step S110). Based on the nameplate order form OF2, the processor 21 newly creates management information 23D illustrated in FIG. 13, thereby updating the management information 23.

When the management information 23B illustrated in FIG. 8 and the management information 23D illustrated in FIG. 13 are compared, they have the identical "S/N" that is "91P123456", they have the identical "CALRNG" that is "0 to 50 kPa", they have the identical "TAG No." that is "ABCDEFGHIJKLMNOP", and they have the same "FREE" space that is blank. On the other hand, "Rev" is updated from "0" to "1" and "MS code" is updated from "EJS110-xxxx-xxxx" to "EJS110-xYxx-xxxx". "To do" is set for "NP Replacement" when the management information 23D is created.

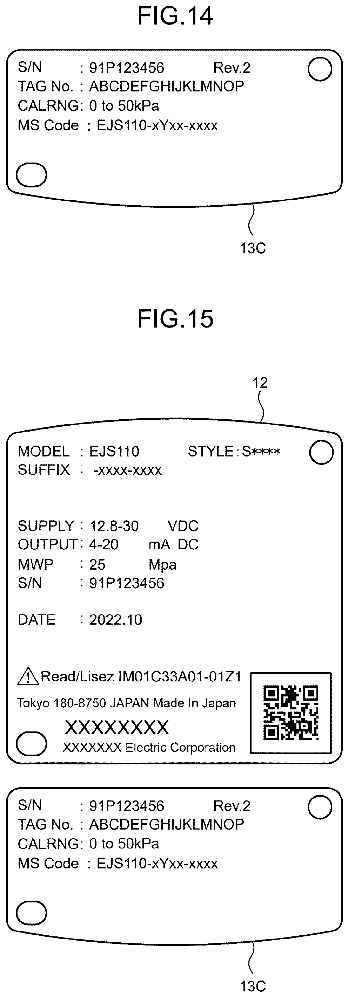

Based on the nameplate order form OF2, the device manufacturer having received the nameplate order form OF2 creates an updated nameplate 13C (FIG. 14) that is new and that is the second nameplate 13 (step S120). When the updated nameplate 13B illustrated in FIG. 9 and the updated nameplate 13C illustrated in FIG. 14 are compared, while they have the identical "S/N" that is "91P123456", they have the identical "TAG No." that is "ABCDEFGHIJKLMNOP", and they have the identical "CALRNG" that is "0 to 50 kPa", "EJS110-xYxx-xxxx" is added as "MS Code". On the updated nameplate 13C, "Rev.2" indicating that the number of times the second nameplate 13 is updated is twice is written. The device manufacturer sends the created updated nameplate 13C to the device user (step S130).

As illustrated in FIG. 15, with the first nameplate 12 being left in the first nameplate 12 and the updated nameplate 13B (FIG. 10) that are fixed to the pressure transmitter 10, the device user having received the updated nameplate 13C replaces only the second nameplate 13 that is the updated nameplate 13B (FIG. 10) with the updated nameplate 13C (FIG. 14) (step S140).

After replacement of the second nameplate 13, using the camera that is installed in the mobile terminal device 30, the device user shoots a nameplate photograph P2 of the first nameplate 12 and the updated nameplate 13C (FIG. 15) that are subjects and that are fixed to the pressure transmitter 10 (step S150).

Subsequently, using the mobile terminal device 30, the device user sends the nameplate photograph P2 to the management apparatus 20 (step S160).

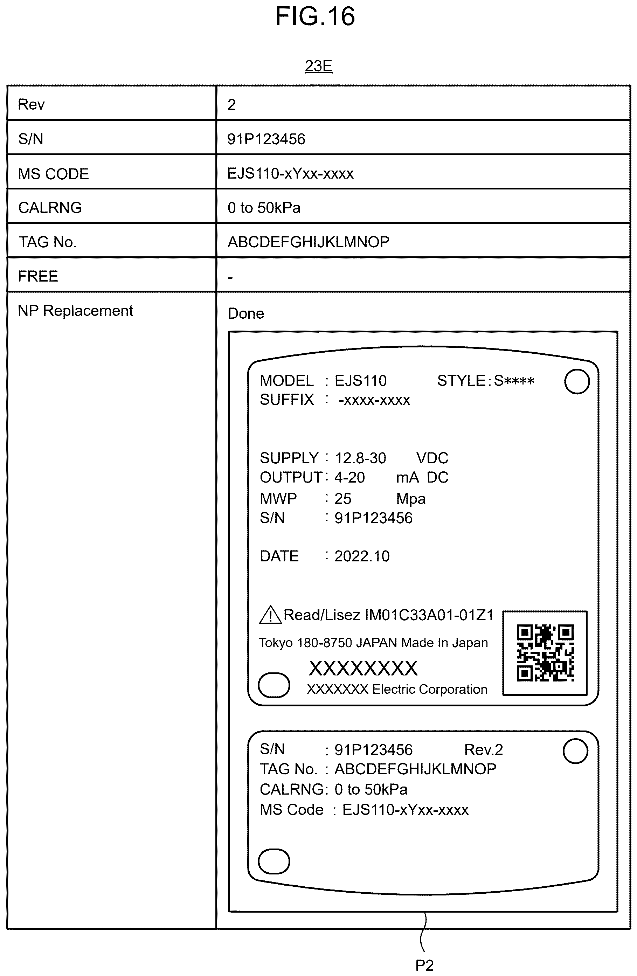

Subsequently, the processor 21 of the management apparatus 20 having received the nameplate photograph P2 adds the nameplate photograph P2 to the "NP Replacement" space in the management information 23D (FIG. 13) and updates "NP Replacement" from "To do" to "Done", thereby updating the management information 23D (FIG. 13) to management information 23E (FIG. 16) (step S170). In other words, addition of the nameplate photograph P2 to the "NP Replacement" space indicates that replacement of the updated nameplate 13B with the updated nameplate 13C has completed.

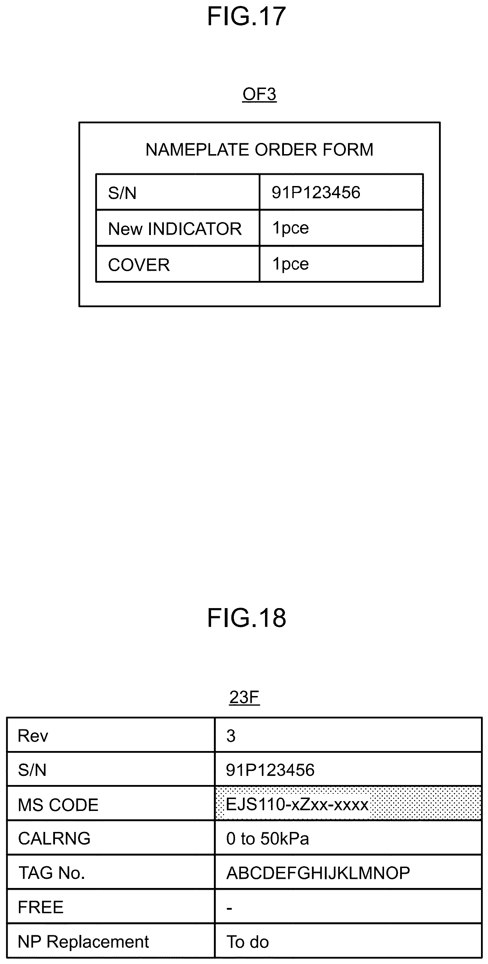

In the case where the device user wants to change INDICATOR fixed to the pressure transmitter 10 to the latest model with the first nameplate 12 and the updated nameplate 13C being fixed to the pressure transmitter 10 as illustrated in FIG. 15, the device user creates a nameplate order form OF3 illustrated in FIG. 17 using the mobile terminal device 30 and sends the created nameplate order form OF3 to the device manufacturer (step S100). In this case, in the nameplate order form OF3, "91P123456" is entered in "S/N", "1pce" is entered in "New INDICATOR", and "1pce" is entered in "COVER". Thus, as for the pressure transmitter 10 whose "S/N" is "91P123456", newly fixing the latest INDICATOR with COVER is ordered from the device user to the device manufacturer.

In the device manufacturer having received the nameplate order form OF3, the processor 21 of the management apparatus 20 updates the management information 23 according to the nameplate order form OF3 (step S110). Based on the nameplate order form OF3, the processor 21 newly creates management information 23F illustrated in FIG. 18, thereby updating the management information 23.

When the management information 23D illustrated in FIG. 13 and the management information 23F illustrated in FIG. 18 are compared, they have the identical "S/N" that is "91P123456", they have the identical "CALRNG" that is "0 to 50 kPa", they have the identical "TAG No." that is "ABCDEFGHIJKLMNOP", and they have the same "FREE" space that is blank. On the other hand, "Rev" is updated from "2" to "3" and "MS code" is updated from "EJS110-xYxx-xxxx" to "EJS110-xZxx-xxxx". "To do" is set for "NP Replacement" when the management information 23F is created.

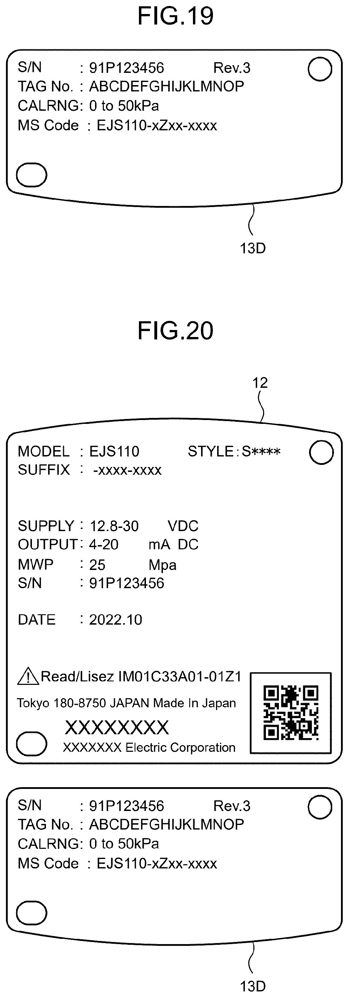

Based on the nameplate order form OF3, the device manufacturer having received the nameplate order form OF3 creates an updated nameplate 13D (FIG. 19) that is new and that is the second nameplate 13 (step S120). When the updated nameplate 13C illustrated in FIG. 14 and the updated nameplate 13D illustrated in FIG. 19 are compared, while they have the identical "S/N" that is "91P123456", they have the identical "TAG No." that is "ABCDEFGHIJKLMNOP", and they have the identical "CALRNG" that is "0 to 50 kPa", "MS Code" is updated from "EJS110-xYxx-xxxx" to "EJS110-xZxx-xxxx". On the updated nameplate 13D, "Rev.3" indicating that the number of times the second nameplate 13 is updated is three times is written. The device manufacturer sends the created updated nameplate 13D to the device user (step S130).

As illustrated in FIG. 20, with the first nameplate 12 being left in the first nameplate 12 and the updated nameplate 13C (FIG. 15) that are fixed to the pressure transmitter 10, the device user having received the updated nameplate 13D replaces only the second nameplate 13 that is the updated nameplate 13C (FIG. 15) with the updated nameplate 13D (FIG. 19) (step S140).

After replacement of the second nameplate 13, using the camera that is installed in the mobile terminal device 30, the device user shoots a nameplate photograph P3 of the first nameplate 12 and the updated nameplate 13D (FIG. 20) that are subjects and that are fixed to the pressure transmitter 10 (step S150).

Subsequently, using the mobile terminal device 30, the device user sends the nameplate photograph P3 to the management apparatus 20 (step S160).

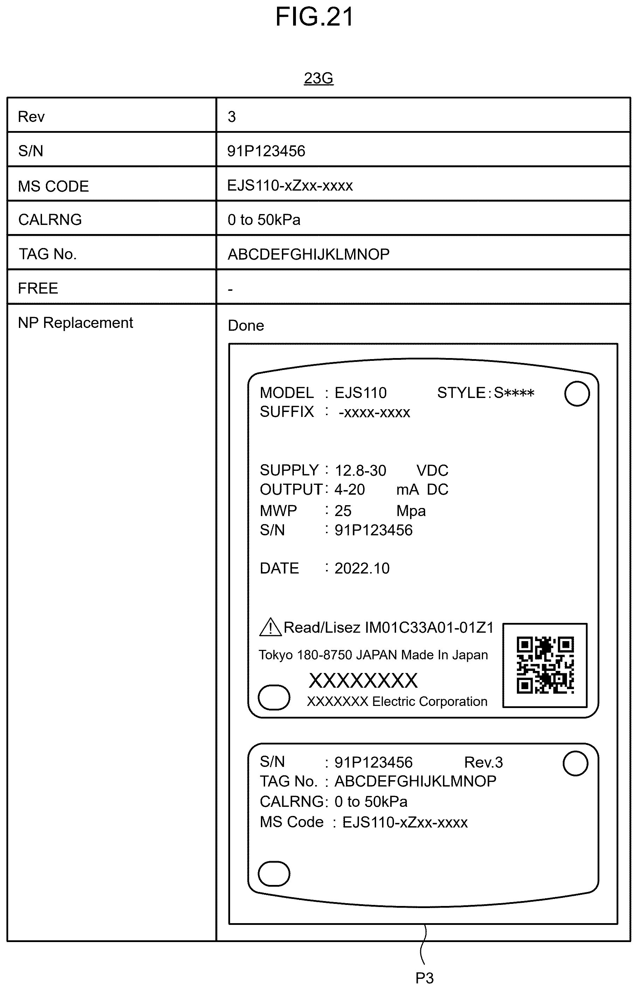

Subsequently, the processor 21 of the management apparatus 20 having received the nameplate photograph P3 adds the nameplate photograph P3 to the "NP Replacement" space in the management information 23F (FIG. 18) and updates "NP Replacement" from "To do" to "Done", thereby updating the management information 23F (FIG. 18) to management information 23G (FIG. 21) (step S170). In other words, addition of the nameplate photograph P3 to the "NP Replacement" space indicates that replacement of the updated nameplate 13C with the updated nameplate 13D has completed.

As in the updated nameplates 13B, 13C and 13D, the changeable latest information on the pressure transmitter 10 is written on the second nameplate 13.

The management apparatus 20 leaves the management information 23A (FIG. 6) in which "Rev" is "0", the management information 23C (FIG. 11) in which "Rev" is "1", the management information 23E (FIG. 16) in which "Rev" is "2", and the management information 23G (FIG. 21) in which "Rev" is "3" in the storage unit 22, thereby managing the history of updating the content of writing on the second nameplate 13.

Note that, in the first embodiment described above, the case where addition of the nameplate photograph to the "NP Replacement" space indicates that replacement of the second nameplate has completed is described as an example. Instead of adding the nameplate photograph to the "NP Replacement" space, however, updating "NP Replacement" from "To do" to "Done" by a terminal device operated by the device user, such as the mobile terminal device 30 or a personal computer, may indicate that replacement of the second nameplate has completed.

The first embodiment has been described.

### Second Embodiment

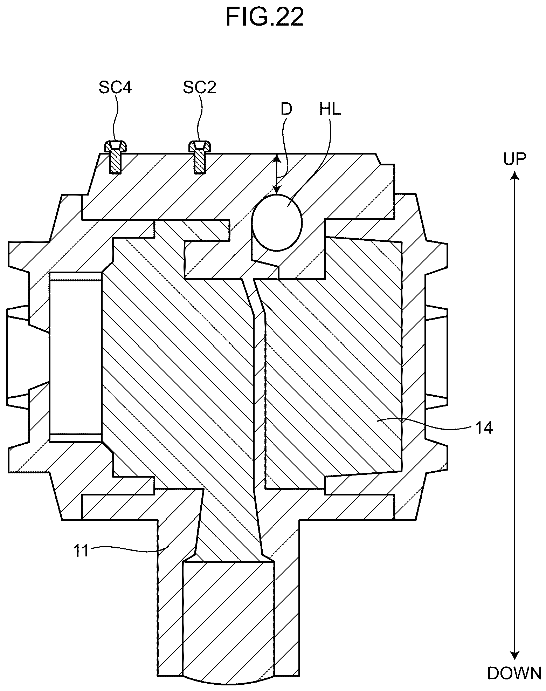

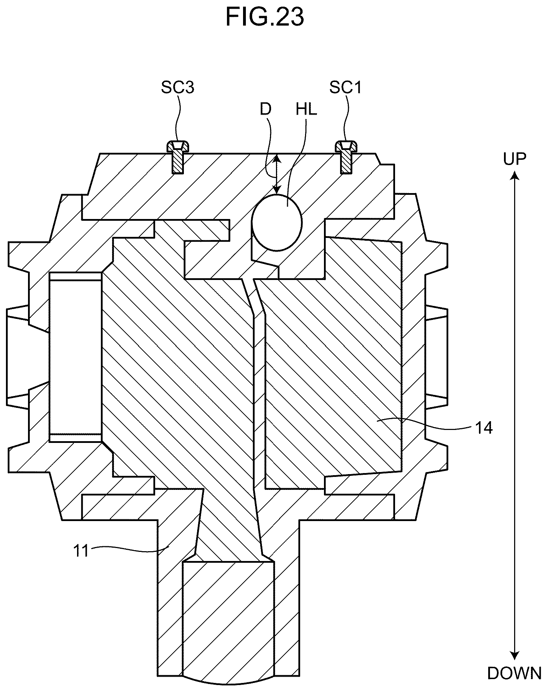

FIG. 22 and FIG. 23 are cross-sectional views of a pressure transmitter of a second embodiment of the disclosure. FIG. 22 illustrates a cross-sectional view of the pressure transmitter 10 illustrated in FIG. 2 taken along the A-A' line and FIG. 23 illustrates a cross-sectional view of the pressure transmitter 10 illustrated in FIG. 2 taken along the B-B' line.

As illustrated in FIG. 2, FIG. 22 and FIG. 23, a wiring port HL through which wires pass is formed in the housing 11. As illustrated in FIG. 2, FIG. 22 and FIG. 23, an electric circuit 14 is housed in the housing 11.

There is an explosive atmosphere containing the electric circuit 14 in the housing 11 and therefore the housing 11 is formed as a pressure-resistant container that is resistant to an explosion and is formed such that flame does not go out of the housing 11 even when an explosion occurs in the housing 11.

There is a requirement according to the standards of the field device in the thickness of the housing 11 such that the housing 11 is sufficiently resistant to explosion in the housing 11.

The wiring port HL is formed by boring processing on the housing 11 and thus deviation occurs in the size of the wiring port or the position of the wiring port HL within a tolerance.

Thus, as illustrated in FIG. 22, the first nameplate 12 is screwed with a second screw SC2 and the second nameplate 13 is screwed with a fourth screw SC4 in positions other than positions above the wiring port HL. Similarly, as illustrated in FIG. 23, the first nameplate 12 is screwed with a first screw SC1 and the second nameplate 13 is screwed with a third screw SC3 in positions other than positions above the wiring port HL. Accordingly, even when the first nameplate 12 and the second nameplate 13 are fixed by screwing to the housing 11 in which the wiring port HL is formed, the thickness D can meet the requirement according to the standards of the field device in all portions in the housing 11.

The second embodiment has been described.

As described above, a management system of the disclosure (the management system 1 of the embodiment) includes a field device (the pressure transmitter 10 of the first embodiment) and a management apparatus (the management apparatus 20 of the embodiment). The field device has a housing to which a first nameplate (the first nameplate 12 of the embodiment) with writing of which content is not updated and a second nameplate (the second nameplate 13 of the embodiment) that is replaceable, that is with writing of which content is updatable, and that is in a pair with the first nameplate are fixed. The management apparatus manages a history of updating the content of writing on the second nameplate.

For example, the changeable latest information on the field device is written on the second nameplate.

The first nameplate with writing of which content is not updated and the second nameplate that is replaceable, that is with writing on which content is updatable, and that is in a pair with the first nameplate are included as described above and therefore, when a change occurs in the device information, it is only required to, with the first nameplate being fixed to the field device, replace only the second nameplate. Thus, according to the configuration, it is possible to reduce risk in managing the field device.

The management apparatus manages the history of updating the content of writing on the second nameplate and thus it is possible to provide useful information, such as trouble information, to a device user.

Serial numbers that are identical are written on the first nameplate and the second nameplate.

This makes it possible to easily distinguish the first nameplate and the second nameplate that are in a pair and thus it is possible to prevent incorrect fixation of the second nameplate to the field device.

The management system of the disclosure further includes a mobile terminal device (the mobile terminal device 30 of the embodiment). The mobile terminal device has a camera that shoots a photograph of the first nameplate and the second nameplate that are subjects and adds the photograph shot by the mobile terminal device to the history of the updating.

This enables the device user to leave evidence of replacement of the second nameplate in the management apparatus using the mobile terminal device.

According to the disclosure, it is possible to reduce risk in managing the field device.

## Claims

1. A management system (1) comprising a field device (10) and a management apparatus (20),
wherein the field device (10) has a housing (11) to which a first nameplate (12) with writing of which content is not updated and a second nameplate (13) that is replaceable, that is with writing of which content is updatable, and that is in a pair with the first nameplate are fixed, and
the management apparatus (20) manages a history of updating the content of writing on the second nameplate (13).

2. The management system (1) according to claim 1, wherein serial numbers that are identical are written on the first nameplate (12) and the second nameplate (13).

3. The management system (1) according to claim 1 or 2, wherein information on the field device (10) that is the latest and that is changeable is written on the second nameplate (13).

4. The management system (1) according to any one of claims 1 to 3, wherein the management apparatus (20) adds a photograph of the first nameplate (12) and the second nameplate (13) that are subjects to the history of the updating.

5. The management system (1) according to any one of claims 1 to 3, wherein the history of the updating is updated by a terminal device (30) that is able to communicate with the management apparatus (20).

6. A field device (10) comprising:
a housing (11);
a first nameplate (12) that is fixed to the housing and that is with writing of which content is not updated; and
a second nameplate (13) that is fixed to the housing, that is replaceable, that is with writing of which content is updatable, and that is in a pair with the first nameplate.

7. The field device (10) according to claim 6, wherein the first nameplate (12) and the second nameplate (13) are fixed to the housing by screwing, and
the screwing is performed in a position other than a position above a wiring port that is formed in the housing (11).

8. A management apparatus (20) comprising a processor (21) and a storage unit (22), wherein the processor (21) manages a history of updating content of writing on a second nameplate (13) of a field device (10) by recording the history of the updating in the storage unit (22), the field device (10) including:
a housing (11);
a first nameplate (12) that is fixed to the housing (11) and that is with writing of which content is not updated; and
the second nameplate (13) that is fixed to the housing (11), that is replaceable, that is with writing of which content is updatable, and that is in a pair with the first nameplate (12).

9. A management method performed by a management apparatus, the management method comprising managing a history of updating content of writing on a second nameplate,
wherein a first nameplate with writing of which content is not updated and the second nameplate that is replaceable, that is with writing of which content is updatable, and that is in a pair with the first nameplate are fixed to a housing of a field device.
